# EUROPEAN PATENT APPLICATION

(11) **EP 4 808 293 A1**
(43) Date of publication of application: **16.09.2026**
(21) Application number: 25162709.7
(22) Date of filing: 10.03.2025
(51) Int. Cl.: H05K 5/00, H05K 7/20

(54) **ELECTRONIC CONTROL DEVICE FOR A MOTOR VEHICLE, MOTOR VEHICLE AND METHOD FOR MANUFACTURING AN ELECTRONIC CONTROL DEVICE**

(71) Applicant: Connaught Electronics Ltd., County Galway H54 Y276 (IE)
(72) Inventor: BOGIEL, Justyna, Tuam, H54 Y276 (IE)
(74) Representative: Jauregui Urbahn, Kristian

(57) **Abstract**

The invention is directed at an Electronic control device (10) for a motor vehicle (36), comprising
- a housing with a housing interior, the housing comprising an upper housing part (12) and a lower housing part (26), which in an assembled state form the interior of the housing,
- a printed circuit board (28), which is arranged inside the interior of the housing, and
- at least one electrical component (22), which is arranged on the printed circuit board (28), wherein the at least one electronic component (22) is thermally conductively coupled to a cooling plate (14), which is integrated into at least one of the housing parts (12, 26), in particular into the upper housing part (12). At least one surface of the housing, which faces the interior of the housing, is at least partially coated with a thermally insulating coating (34).

## Description

The invention is directed at an electronic control device for a motor vehicle, comprising a housing with a housing interior, a printed circuit board, which is arranged in the housing interior, and at least one electronic component, which is arranged on the printed circuit board. For cooling the at least one electronic component, it is thermally conductively coupled to a cooling plate, which is integrated into the housing, in particular into an upper part of the housing. A further aspect of the invention is directed at a motor vehicle with such an electronic control device. A further aspect of the invention is directed at a method for manufacturing an electronic control device for a motor vehicle.

The functionality and computing power of computing systems for vehicles increases as more and more sophisticated applications are installed in the vehicles, for example applications for driver assistance systems or other semi-automatic or fully automatic driving functions. In particular, the computing power of electronic control devices such as electronic control units (ECUs), domain control units (DCUs) or zone control units (ZPUs) of the vehicles increases, which causes an increase in the heat dissipation of electronic components of those and other devices. Accordingly, temperatures inside housing interiors of such electronic control units can rise up to 100 or 110 degrees Celsius. It is therefore known to use active or passive cooling solutions by means of a cooling fluid or cooling liquid or air for these electronic components.

In active cooling solutions, the cooling fluid or liquid (short: coolant) typically circulates within a cooling plate or within one or more cooling channels of such a cooling plate, which comprises a cooling surface, which is in thermal contact with the electronic component(s) to be cooled. In order to provide the thermal contact, the cooling plate is typically arranged together with the electronic component(s) to be cooled inside the interior space of the housing of the electronic control device. Preferably, the housing also offers space for arranging a printed circuit board (PCB) and other electronic components and/or connecting interfaces for connecting the electronic device to a communication network of the vehicle.

In passive cooling solutions, the housing of the ECU itself may be used as a cooling component. The cooling surface in this case may be an inside surface of the housing. With passive cooling solutions, typically a number of heat dissipating elements, for example fins or ribs or the like, are arranged along an outside surface of the housing. These elements increase the surface of the housing and therefore increase the heat transfer from the housing towards its environment via air cooling.

In the known cooling solutions, may it be active or passive cooling, it is a known effect that due to the temperature difference between the air inside the housing interior and the cooling surface, condensation may occur on the cooling surface and/or on other surfaces of the housing, which face the interior of the housing. Condensate may eventually form droplets of water, which may drop onto the PCB and the electronic components, which are mounted thereon. This may lead to malfunction of the electronic components and therefore should be avoided.

It is known to use a conformal coating, which covers the fully equipped PCB in order to provide a protective cover for the electronic components mounted thereon. This can become problematic, if the need arises to rework parts of the PCB, which may not be easily accessible anymore, once they are covered with the conformal coating.

CN219660098U describes an assembly of an electric control box with a liquid-cooled end box fixedly installed on a top surface of the electric control box. The cold end box is connected to a refrigeration coil for actively cooling a bottom surface of the end box. Condensation is deliberately forced by cooling down the bottom surface. Condensate water is then guided by condensation guide grooves towards a liquid collection ditch. In other words, controlled condensation is forced by spending additional cooling energy for operating the refrigeration coil. This lowers the efficiency of the described electric control box.

It is an object of the present invention to protect the electronic components of an electronic control device from condensate water and at the same time to avoid the disadvantages of the known solutions.

The object is solved by the subject matters of the independent patent claims. Advantageous further embodiments of the invention are described by the dependent patent claims, the following description and the figures.

The invention is based on the realization, that for protecting the electronic components of an electronic control device from condensate water, it can be beneficial to avoid or at least delay the formation of condensate water. This can be done by minimizing the effect of a "cold surface" in the comparably hot environment inside the interior of the housing.

The invention is directed at an electronic control device for a motor vehicle of the above described type. The electronic control device in particular comprises a housing with a housing interior, the housing comprising an upper housing part and a lower housing part, which in an assembled state form the interior of the housing. In other words, the housing may be formed by the upper and the lower housing parts, which are put together in the assembled state in order to form the housing interior. The housing parts may for example be made from a metal, preferably from aluminum.

Inside the housing interior, a printed circuit board may be arranged, which may carry at least one electrical component, which is arranged on the printed circuit board. The electronic component may be an SOC (system on a chip) or any other computing unit. In order to cool the electronic component, it is thermally conductively coupled to a cooling plate, which is integrated into at least one of the housing parts, in particular into the upper housing part. The at least one electronic component may be directly or indirectly thermally conductively coupled to the cooling surface. The electronic control unit according to the invention may be actively or passively cooled.

According to the invention, at least one surface of the housing, which faces the interior of the housing, is at least partially coated with a thermally insulating coating. The coating can be applied to the inside surface of the upper housing part and/or on the inside surface of the lower housing part. Preferably, the coating is only applied to the inside surface of the upper housing part. The effect of the thermally insulating coating is that the temperature difference between the at least one coated surface and the air inside the interior of the housing, which may be heated up by the waste heat, which occurs during operation of the at least one electronic component, is decreased by applying the thermally insulating coating on the surface. Preferably, the coating is applied to an inner surface of the housing, which, in a preferred mounting position of the electronic control device inside the motor vehicle, is arranged above the PCB, such that condensate water would drop onto the PCB from the surface due to gravity if it weren't for the coating.

The invention is advantageous in that, due to the decrease in temperature difference, the occurrence of condensation may be avoided or at least delayed without spending additional energy. Furthermore, no additional protective cover over the PCB is needed, as the risk of condensate water dropping onto the PCB is decreased.

Further embodiments of the invention provide additional advantages.

According to an embodiment, the cooling plate comprises a cooling surface, which also faces the interior of the housing. The at least one electronic component to be cooled is thermally conductively coupled to the cooling surface of the cooling plate. In other words, in the assembled state of the upper and lower housing parts, the cooling plate, which is integrated into one of the housing parts, preferably in the upper housing part, faces with its cooling surface the interior of the housing. In other words, the cooling surface is an inner surface of the housing, which faces the interior of the housing. Like this, the at least one electronic component can be thermally conductively coupled to the cooling surface by arranging it in direct physical contact with the cooling surface. In other words, the electronic component to be cooled and the cooling surface can touch each other. This allows very efficient heat transfer from the electronic component to the cooling plate. Due to the increased efficiency, the cooling temperature of the cooling plate can be adjusted higher as in the known solutions, which further reduces the risk of condensation.

According to a further embodiment, the at least one surface of the housing, which is at least partially coated with the thermally insulating coating, comprises the cooling surface of the cooling plate. In other words, the cooling plate is at least partially covered by the coating or at least partially coated with the thermally insulating coating. This has the further advantage of reducing the amount of "cold surface" in the housing interior, thus further reducing the risk of condensation.

Of course, the cooling plate still has to work as a cooling device for the at least one electronic component to be cooled. In order to properly work as a cooling device, the cooling plate or its cooling surface should not be covered completely with the thermally insulating coating. In other words, parts of the cooling surface should remain free from coating.

According to a further embodiment, the at least one electronic component to be cooled is thermally conductively coupled to the cooling surface via a sheet of thermal interface material, wherein the sheet of thermal interface material at least partially replaces the thermally insulating coating between the at least one electronic component and the cooling surface. In other words, there preferably is no insulating coating between the at least one electronic component to be cooled and the cooling surface. Instead, the insulating coating is replaced in this area by the thermal interface material, which may be a thermally conductive paste. Like this, the amount of "cold surface" inside the housing interior is advantageously reduced and the cooling capability of the cooling plate remains fully preserved.

Preferably, the cooling surface comprises at least one pedestal, which protrudes from the cooling surface towards the at least one electronic component to be cooled, wherein the thermal interface material is arranged between the at least one pedestal and the at least one electronic component. In other words, the cooling surface is in contact with the at least one electronic component to be cooled in an area, where it has a protrusion - the pedestal. Due to this geometry, the thermally insulating coating can easily be removed from the contact surface between the cooling plate and the electronic component in a post manufacturing step.

According to a further embodiment, the thermally insulating coating comprises a ceramic, a plastic and/or a rubber. It can preferably be sprayed onto the surface to be coated, or painted on the surface. Alternatively, the surface to be coated may also be immersed into a coating bath.

According to a further embodiment, the thermally insulating coating comprises a hydrophilic material component. In other words, the thermally insulating coating is adapted to attract water. Preferably, the thermally insulating coating comprises an open porosity, which is adapted to absorb a liquid, in particular water. The open porosity may also enhance the thermally insulating effect of the coating. In other words, the thermally insulating coating may act like a sponge, when it comes into contact with water, for example condensate water. As described earlier, condensation may be avoided or at least delayed by the invention. In the case of a delay, condensation may occur eventually. In this case, the thermally insulating coating may also be able to attract and to bind condensate water, thus further reducing the risk of damaging the electronic components on the PCB.

According to a further embodiment, the at least one surface of the housing comprises structural elements for directing or guiding a fluid flow, in particular a flow of water condensate, along the at least one surface towards a predetermined collecting area inside the interior of the housing or outside of the housing. In other words, should the insulating coating be saturated with condensate water, the excess water can be directed in a controlled manner towards an area inside the housing interior, where it cannot harm the electronic components. In this collecting area, also a drainage hole may be arranged, such that the condensate water can be guided out of the housing interior. Preferably, the structural elements are at least partially integrated into the thermally insulating coating. In other words, the structural elements may be formed into the thermally insulating coating. For example, the thermally insulating coating may be made of or comprise a ceramic. The structural elements may be formed into the ceramic before it is cured and hardened.

According to a further embodiment, the electronic control device is a control device of the motor vehicle, which is designed to control at least one vehicle function of the motor vehicle. In other words, the electronic device is a control device for controlling at least one vehicle function of the motor vehicle, in particular an electronic control unit (ECU), which can preferably be used for motor vehicles.

In particular, a vehicle-centric, zone-oriented architecture of the electrical or electronic components of the motor vehicle can be provided for the motor vehicle. In particular, at least one main controller, for example a single main controller, can be provided in such a vehicle architecture, which can also be referred to as the main control unit or vehicle computer, and which can be designed to perform the main computing operations for vehicle-specific applications, for example autonomous driving.

The main controller may be connected to several, preferably four, zonal controllers, which may also be referred to as zone controllers, by means of signaling technology. Zonal controllers can be designed to perform less demanding computing operations compared to the main computing operations of the main controller.

For example, the electronic vehicle architecture can be divided into zones, preferably four zones, wherein a zonal controller can be provided for each zone. In particular, the main controller can be connected via the zonal controllers to other electrical and electronic components of the motor vehicle, in particular to smaller, distributed control units, as well as to a large number of sensors and actuators of the motor vehicle.

Such a vehicle-centric, zone-oriented architecture of the electrical or electronic components can be advantageous at least to the extent that they are less complex than domain-oriented architectures. In particular, the computing operations of the complex, vehicle-specific applications of distributed control units can be consolidated on a single or on a few, very powerful main controllers.

Preferably, the electronic assembly according to the invention can be a main controller of the motor vehicle. Alternatively, the electronic assembly according to the invention may be a zonal controller of the motor vehicle. Accordingly, the cooling device according to the invention can be provided for cooling the powerful electronic components of a main controller or a zonal controller.

The electronic component may in particular be a component of the ECU, in particular a SoC, a microchip, a processor, an integrated circuit or the like, wherein the powerful electronic component generates harmful waste heat during operation, which must be dissipated by means of the cooling device.

A further aspect of the invention relates to a motor vehicle comprising an electronic device according to the invention.

A further aspect of the invention is directed at a method manufacturing an electronic control device according to any of the above-described embodiment, comprising the steps of
- providing a housing of the electronic control device, comprising an upper housing part and a lower housing part, which in an assembled state form an interior of the housing,
- coating at least one inner surface of the housing at least partially with a thermally insulating coating, wherein in the assembled state of the upper and the lower housing parts, the coated surface faces the interior of the housing,
- preferably assembling the upper housing part and the lower housing part by putting them together to form the housing interior.

Preferably, the method comprises the additional steps of
- providing a cooling plate with a cooling surface for the housing and integrating it into one of the housing parts, in particular in the upper housing part, such that in the assembled state, the cooling surface faces the interior of the housing,
- coating the cooling surface at least partially with the thermally insulating coating,
- providing a printed circuit board and arranging it on one of the housing parts, in particular on the lower housing part,
- arranging at least one electronic component on the printed circuit board,
- removing parts of the thermally insulating coating from the cooling surface in an area, which in the assembled state faces the at least one electronic component.

Preferably, the step of coating comprises spraying the coating onto the surface and/or painting the surface with the coating and/or immersing the surface into a coating bath. Preferably, the step of removing parts of the thermally insulating coating comprises scratching and/or etching.

The method steps may be carried out in any reasonable order. In particular, the method also comprises the step of assembling the upper and lower housing parts to form the housing interior.

Further embodiments of the motor vehicle and/or the method according to the invention follow directly from the various embodiments of the electronic control device according to the invention and vice versa. In particular, individual features and corresponding explanations as well as advantages relating to the various implementations of the electronic control device according to the invention can be transferred analogously to implementations of the motor vehicle and/or the method according to the invention and vice versa.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

Embodiments of the invention are described below. In the figures:
- Fig. 1: Shows a schematic section view of an electronic control device according to an embodiment of the invention;
- Fig. 2: Shows a further schematic section view of an electronic control device according to an embodiment of the invention;
- Fig. 3: Shows a schematic inside view of an upper housing part of a housing of an electronic control device according to an embodiment of the invention, wherein an inner surface of the upper housing part is at least partially coated with a thermally insulating coating;
- Fig. 4: Shows a further schematic inside view of the upper housing part according to Fig. 3, wherein protruding pedestals along the inner surface are emphasized;
- Fig. 5: Shows a schematic view of a flow chart, illustrating a method for manufacturing an electronic control device according to an embodiment of the invention; and
- Fig. 6: Shows a schematic view of a motor vehicle with an electronic control device according to an embodiment of the invention.

The embodiments explained below are preferred embodiments of the invention. In the embodiments, the described components of the embodiments each represent individual features of the invention which are to be considered independently of each other, which also further form the invention independently of each other and are thus also to be regarded as part of the invention individually or in a combination other than that shown. Furthermore, the embodiment described can also be supplemented by other features of the invention already described.

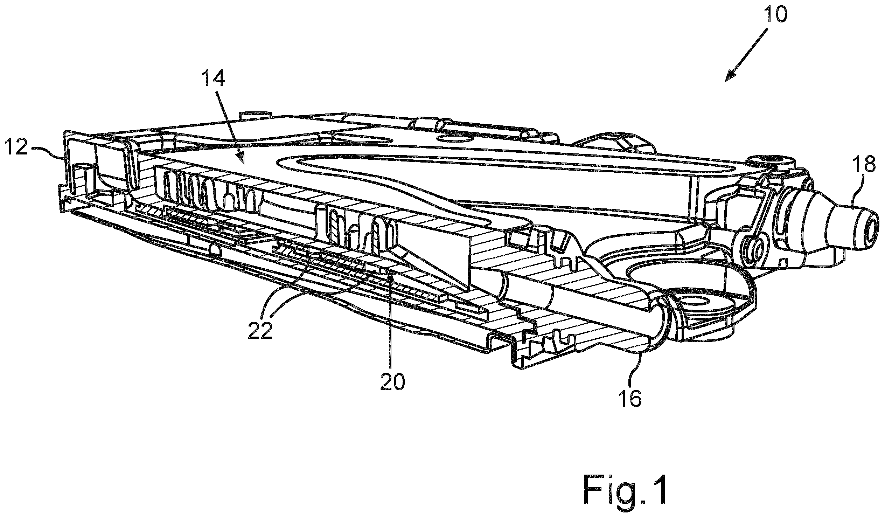

Fig. 1 shows a schematic longitudinal section view of parts of an electronic control device 10 according to an embodiment of the invention. The electronic control device 10 comprises an upper housing part 12 with an integrated cooling plate 14. The cooling plate 14 may comprise one or more cooling channels (not shown) for circulating a cooling liquid, which may be fed to and extracted from the cooling channels via an inlet 16 and an outlet 18, respectively. The cooling plate 14 may form part of the upper housing part 12. It may comprise a cooling surface 20, which may be an inner surface of the housing, i.e. which faces an interior of the housing of the electronic control device 10.

Inside the housing interior, one or more electronic components 22 may be arranged, which may require cooling. Due to their computing power, they may produce heat while in operation, thereby heating the air inside the housing interior up to 100 or 110 degrees Celsius. Therefore, a temperature difference may exist between the hot air inside the housing interior and the liquid cooled cooling surface 20 of the cooling plate 14.

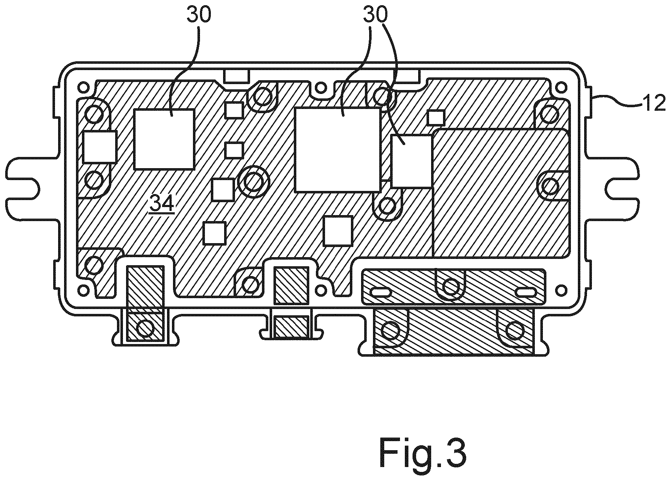

To reduce this temperature difference, a thin layer of thermally insulating coating is applied to the cooling surface 20 of the cooling plate 14 (for the sake of readability of the figure, the coating is not shown in Fig. 1. Referral is made to Fig. 3). The coating may additionally be applied to other inner surfaces of the housing.

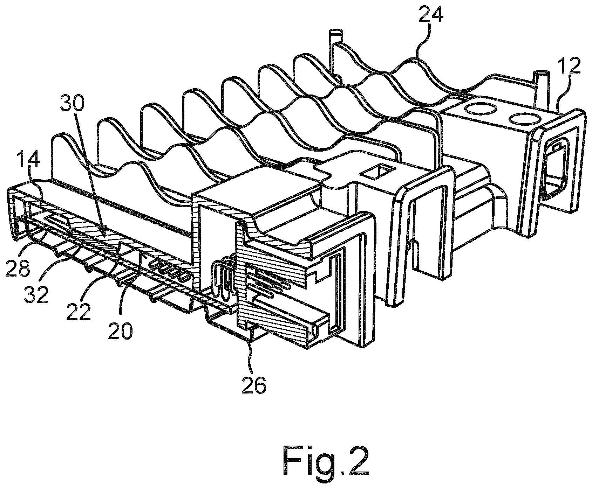

With reference to the components, that were already described in the context of Fig. 1, Fig. 2 shows a further schematic section view of an electronic control device 10 according to an embodiment of the invention. In this embodiment, the housing is passively cooled. Therefore, the upper housing part 12 comprises heat dissipating features 24 in the form of wavy fins protruding towards an environment of the housing. In other words, the upper housing part 24 works as a passive cooling plate 14 without a cooling liquid circuit as the embodiment of Fig. 1. Nevertheless, a temperature difference between the upper housing part 12 and the hot air inside the housing interior may exist, which may eventually lead to condensation on a cooling surface 20 of the cooling plate 14, which faces the housing interior.

Fig. 2 shows a lower housing part 26 of the housing, wherein a printed circuit board (PCB) 28 is arranged on the lower housing part 26 inside the housing interior. One or more of the electronic components 22 to be cooled are arranged on the PCB 28.

In the example shown in Fig. 2, a pedestal 30 protrudes from the cooling surface 20 towards the interior of the housing. The pedestal 30 may be arranged opposite the at least one electronic component 22 to be cooled. The pedestal 30 and the electronic component 22 may be thermally coupled by a thin sheet of thermal interface material 32. In order to facilitate efficient heat transfer from the electronic component 22 to the pedestal 30, the pedestal 30 may be free from thermally insulating coating, whereas the remaining parts of the cooling surface 20 may be covered by thermally insulating coating.

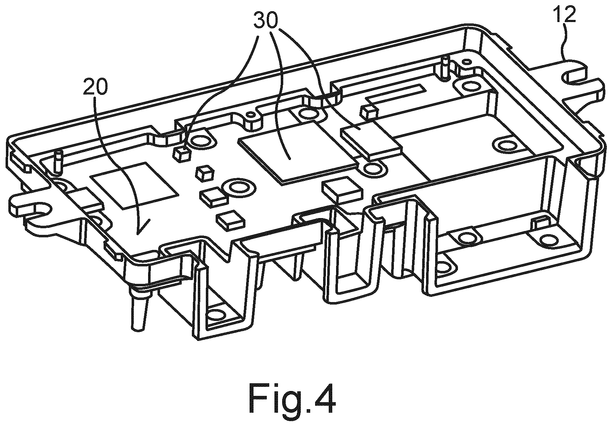

With reference to the components, that were already described in the context of Fig. 1 and Fig. 2, Fig. 3 shows a schematic inside view of an upper housing part 12 of a housing of an electronic control device 10 according to an embodiment of the invention, wherein an inner surface of the upper housing part 12 is at least partially coated with a thermally insulating coating 34, indicated by the hatching. As becomes clearly visible from Fig. 4, the pedestals 30, as shown in Fig. 3 and Fig. 4, protrude from the inner surface of the upper housing part 12, which forms the cooling surface 20 of the cooling plate 14, which is integrally formed with the upper housing part 12. The pedestals 30 are free from thermally insulating coating 34 in order to allow efficient heat transfer from the electronic components 22 towards the cooling surface 20.

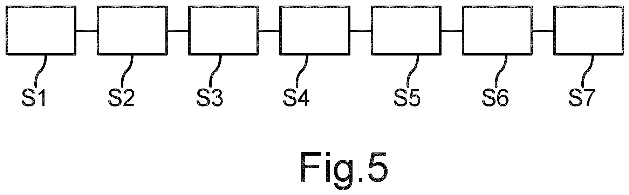

Fig. 5 shows a schematic view of a flow chart, illustrating a method for manufacturing an electronic control device 10 according to an embodiment of the invention.

The method may comprise the steps of
- providing (S1) a housing of the electronic control device 10, comprising an upper housing part 12 and a lower housing part 26, which in an assembled state form an interior of the housing,
- providing (S2) a cooling plate 14 with a cooling surface 20 for the housing and integrating it into one of the housing parts 12, 26, in particular in the upper housing part 12, such that in an assembled state, the cooling surface 20 faces the interior of the housing,
- coating (S3) the cooling surface 20 at least partially with a thermally insulating coating 34,
- providing (S4) a printed circuit board 28 and arranging it on one of the housing parts 12, 26, in particular on the lower housing part 26,
- arranging (S5) at least one electronic component 22 on the printed circuit board 28,
- removing (S6) parts of the thermally insulating coating 34 from the cooling surface 20 in an area, which in the assembled state faces the at least one electronic component 22, and
- assembling (S7) the upper housing part 12 and the lower housing part 26, such that they form the housing interior, wherein in the assembled state, in the housing interior the at least one electronic component 22 faces a part of the cooling surface 20, which was freed from the thermally insulating coating 34.

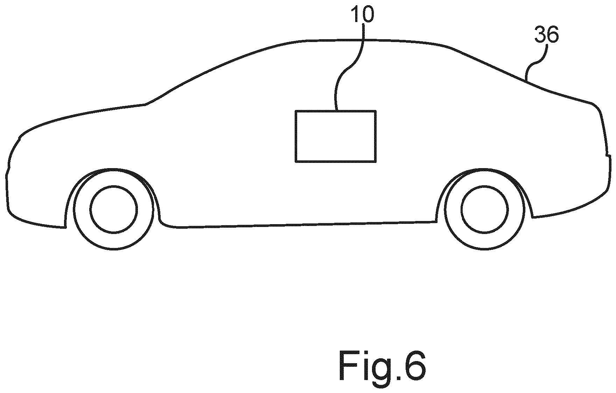

Fig. 6 shows a schematic view of a motor vehicle 36 with an electronic control device 10 according to an embodiment of the invention. The electronic control device 10 may be a device for controlling at least one vehicle function of the motor vehicle 36, for example a motor control device.

As ECU and DC technology evolves we find ourselves having to design larger, increasingly powerful, and expensive products. More and more of the ECUs and DCs are using liquid cooling solutions to keep up with the computing demands. Using this cooling solution increases the risk of condensation forming on the inside of the housings, collecting, and eventually dripping on the PCB. This is especially true in situations when ECUs and DCs are ran in low temperatures.

The air inside the ECU is rapidly heated up by the PCB and its components while the housing remains relatively cool due to the liquid inside the cooling channel. This is less extreme but also true for passively cooled assemblies. This creates a high temperature differential between the housing surface and the ambient temperature, creating a very real and high risk of condensation formation.

Condensation inside electronic assemblies can cause corrosion, short circuiting, diminished performance and other and therefore should be avoided or at least delayed.

The invention proposes to use an insulating material to coat the inside of the ECU and DC housing/s. The aim is to reduce the temperature differential and remove the presence of a "cold surface" where condensation can form. Additionally, the insulating material may be made using a polymer or other with the correct surface tension that will act as a spreader of moisture or absorber rather than allowing a collection to occur and droplets to form. This will further reduce the risk of water dripping onto PCB components.

The insulating material would need to be removed from areas where thermal or electrical contact need to be maintained. This can be done in a post machining step or by covering the areas in question during the coating step.

There is low risk with this as the thermal contact areas will be fully covered by thermal paste not allowing any formation of droplets, while the electrical contact points are further away from hot air areas already minimizing the risk.

Overall, the examples show a possible way to protect the electronic components of an electronic control device from condensate water and at the same time to avoid the disadvantages of the known solutions.

## Claims

1. Electronic control device (10) for a motor vehicle (36), comprising
- a housing with a housing interior, the housing comprising an upper housing part (12) and a lower housing part (26), which in an assembled state form the interior of the housing,
- a printed circuit board (28), which is arranged inside the interior of the housing, and
- at least one electrical component (22), which is arranged on the printed circuit board (28),
wherein the at least one electronic component (22) is thermally conductively coupled to a cooling plate (14), which is integrated into at least one of the housing parts (12, 26), in particular into the upper housing part (12),
**characterized in that**
at least one surface of the housing, which faces the interior of the housing, is at least partially coated with a thermally insulating coating (34).

2. Electronic control device (10) according to claim 1, wherein the cooling plate (14) comprises a cooling surface (20), wherein the at least one electronic component (22) to be cooled is thermally conductively coupled to the cooling surface (20).

3. Electronic control device (10) according to claim 2, wherein the at least one surface of the housing, which is at least partially coated with the thermally insulating coating (34), comprises the cooling surface (20) of the cooling plate (14).

4. Electronic control device (10) according to any of claims 2 or 3, wherein the at least one electronic component (22) to be cooled is thermally conductively coupled to the cooling surface (20) via a sheet of thermal interface material (32), wherein the sheet of thermal interface material (32) at least partially replaces the thermally insulating coating (34) between the at least one electronic component (22) and the cooling surface (20).

5. Electronic control device (10) according to claim 4, wherein the cooling surface (20) comprises at least one pedestal (30), which protrudes from the cooling surface (20) towards the at least one electronic component (22) to be cooled, wherein the thermal interface material (32) is arranged between the at least one pedestal (30) and the at least one electronic component (22).

6. Electronic control device (10) according to any of the preceding claims, wherein the thermally insulating coating (34) comprises a ceramic, a plastic and/or a rubber.

7. Electronic control device (10) according to any of the preceding claims, wherein the thermally insulating coating (34) comprises a hydrophilic material component.

8. Electronic control device (10) according to any of the preceding claims, wherein the thermally insulating coating (34) comprises an open porosity, which is adapted to absorb a liquid, in particular water.

9. Electronic control device (10) according to any of the preceding claims, wherein the at least one surface of the housing comprises structural elements for directing a fluid flow, in particular a flow of water condensate, along the at least one surface towards a predetermined collecting area inside the interior of the housing or outside of the housing.

10. Electronic control device (10) according to claim 9, wherein the structural elements are at least partially integrated into the thermally insulating coating (34).

11. Electronic control device (10) according to any of the preceding claims, wherein the electronic control device (10) is a control device of the motor vehicle (36), which is designed to control at least one vehicle function of the motor vehicle (36).

12. Motor vehicle (36) with an electronic control device (10) according to any of the preceding claims.

13. Method for manufacturing an electronic control device (10) according to any of claims 1 to 11, comprising the steps of
- providing a housing of the electronic control device (10), comprising an upper housing part (12) and a lower housing part (26), which in an assembled state form an interior of the housing,
- coating at least one surface of the housing at least partially with a thermally insulating coating (34), wherein in the assembled state of the upper and the lower housing parts (12, 26), the coated surface faces the interior of the housing.

14. Method according to claim 13, comprising the additional steps of
- providing a cooling plate (14) with a cooling surface (20) for the housing and integrating it into one of the housing parts (12, 26), in particular in the upper housing part (12), such that in the assembled state, the cooling surface (20) faces the interior of the housing,
- coating the cooling surface (20) at least partially with the thermally insulating coating (34),
- providing a printed circuit board (28) and arranging it on one of the housing parts (12, 26), in particular on the lower housing part (26),
- arranging at least one electronic component (22) on the printed circuit board (28),
- removing parts of the thermally insulating coating (34) from the cooling surface (20) in an area, which in the assembled state faces the at least one electronic component (22).

15. Method according to any of claims 13 or 14, wherein the step of coating comprises spraying the coating (34) onto the surface and/or painting the surface with the coating (34) and/or immersing the surface into a coating bath.
